(19) **Europäisches Patentamt / European Patent Office / Office européen des brevets**

(11) **EP 1 889 306 B1**

(12) **EUROPEAN PATENT SPECIFICATION**

(45) Date of publication and mention
of the grant of the patent:
**23.03.2011 Bulletin 2011/12**

(21) Application number: **06747255.5**

(22) Date of filing: **05.06.2006**

(51) Int Cl.:
*H01L 41/22* (2006.01)     *H01L 39/24* (2006.01)
*H01L 21/20* (2006.01)     *H01L 21/316* (2006.01)

(86) International application number:
**PCT/JP2006/311666**

(87) International publication number:
**WO 2006/132379 (14.12.2006 Gazette 2006/50)**

(54) **STRUCTURE FOR FUNCTIONAL FILM PATTERN FORMATION AND METHOD OF MANUFACTURING FUNCTIONAL FILM**

STRUKTUR ZUR FORMUNG EINES MUSTERS FÜR EINE FUNKTIONELLE FOLIE UND VERFAHREN ZUR HERSTELLUNG DER FUNKTIONELLEN FOLIE

STRUCTURE DE FORMATION DE MOTIFS DE FILM FONCTIONNEL ET PROCEDE DE PRODUCTION DUDIT FILM FONCTIONNEL

(84) Designated Contracting States:
**DE FR GB**

(30) Priority: **07.06.2005 JP 2005166400**

(43) Date of publication of application:
**20.02.2008 Bulletin 2008/08**

(73) Proprietor: **FUJIFILM Corporation**
**Minato-ku**
**Tokyo 106-8620 (JP)**

(72) Inventor: **Sakashita, Yukio**
**Kanagawa 2588577 (JP)**

(74) Representative: **Klunker, Hans-Friedrich**
**Klunker Schmitt-Nilson Hirsch**
**Patentanwälte**
**Destouchesstrasse 68**
**80796 München (DE)**

(56) References cited:
**EP-A- 0 261 400          EP-A- 0 382 661**
**EP-A- 1 318 551          WO-A-03/032384**
**US-A1- 2002 066 524**

- YUN C H ET AL: "THERMAL AND MECHANICAL SEPARATIONS OF SILLICON LAYERS FROM HYDROGEN PATTERN-IMPLANTED WAFERS" JOURNAL OF ELECTRONIC MATERIALS, WARRENDALE, PA, US, vol. 30, no. 8, August 2001 (2001-08), pages 960-964, XP008005517
- USAMI T ET AL: "THE INFLUENCE OF FLUORINE DESORPTION FROM ECR-CVD SIOF FILM" NEC RESEARCH AND DEVELOPMENT, NIPPON ELECTRIC LTD. TOKYO, JP, vol. 40, no. 3, July 1999 (1999-07), pages 340-344, XP000908389 ISSN: 0547-051X
- XU B ET AL INSTITUTE OF ELECTRICAL AND ELECTRONICS ENGINEERS: "Fabrication of piezoelectric thick films for high frequency transducers" 2003 IEEE ULTRASONICS SYMPOSIUM PROCEEDINGS. HONOLULU, HAWAII, OCT. 5, vol. VOL. 1 OF 2, 5 October 2003 (2003-10-05), pages 1999-2002, XP010701920 ISBN: 0-7803-7922-5

## Description

### TECHNICAL FIELD

The present invention relates to a structure for functional film pattern formation to be used in a manufacturing process of the functional film according to the preamble of claim 1.

The present invention also relates to a method of manufacturing a functional film according to the preamble of claim 18. The functional film may include a dielectric material, piezoelectric material, pyroelectric material, magnetic material, semiconductor material or the like. Specifically, it relates a method of manufacturing the functional film having a pattern.

### BACKGROUND ART

Recent years, in response to the needs for electronic devices such as miniaturization, speeding up, integration, and multifunctionality, the manufacture of devices containing functional materials such as electronic ceramics, which express predetermined functions by being applied with electric fields or magnetic fields and include a dielectric material, piezoelectric material, magnetic material, pyroelectric material and semiconductor material, by using various film formation technologies has been actively studied.

For example, in order to enable high-definition and high-quality printing in an inkjet printer, it is necessary to miniaturize and highly integrate ink nozzles of inkjet heads. Accordingly, it is also necessary to similarly miniaturize and highly integrate piezoelectric actuators for driving the respective ink nozzles. In such a case, a film formation technology, that enables formation of a thinner layer than a bulk material and formation of fine patterns, is desired, and film formation technologies such as a sputtering method, a sol-gel method, and an aerosol deposition method have been studied.

Conventionally, photolithography has been used for patterning a film of functional material (also simply referred to as "functional film"). That is, schematically, a functional film layer is formed on a substrate, a mask pattern is formed by applying a resist onto the film and performing exposure to light and development thereon, and further, the functional film layer is dry etched or wet etched, and thereby, a functional film pattern is obtained.

However, it is known that the functional film formed by film formation does not sufficiently exert its function in a condition after the film formation, and the film is inferior to a bulk material in performance. Accordingly, in order to sufficiently express the function of a functional film, heat treatment at relatively high temperature (e.g., about 500°C to 1000°C) is required after film formation. Further, since a film formation substrate is simultaneously heat-treated when the heat treatment is performed on the functional film, high heat tolerance is required for the material of film formation substrate. On the other hand, in the case where a fabricated function film is utilized, there is demand for using various kinds of substrates according to instruments such as a flexibly substrate made of resin, for example. Accordingly, a method has been studied by which a functional film formed on a film formation substrate can be peeled or transferred from the film formation substrate without hindering its function.

As a related technology, Japanese Patent Application Publication JP-P2005-64289A discloses a method for forming a high-density micropattern. The method includes the steps of forming an organic monomolecular film on a first substrate, microfabricating the organic monomolecular film by photolithography to form an organic monomolecular film pattern, selectively growing a thin film on the organic monomolecular film pattern, and transferring the thin film onto a second substrate to form a micropattern of the thin film on the second substrate (page 2).

According to the method disclosed in JP-P2005-64289A, the patterned functional film (the thin film 15 shown in Fig. 4 of JP-P2005-64289A) can be transferred relatively easily. However, the organic monomolecular film is used in this method, and therefore, it is impossible to form the functional film by a high-temperature process nor perform high-temperature heat treatment on the formed functional film.

WO 03/032384 A1 discloses a structure for functional film pattern formation, in which cracks and fissures in a substrate are produced by gas implantation and releasing such gas in a moment of e. g. heating. There does not occur generation of a gas.

### DISCLOSURE OF THE INVENTION

Accordingly, in view of the above-mentioned problems, a first purpose, of the present invention is to provide a method of manufacturing a functional film by which a fine pattern can be formed. Further, a second purpose of the present invention is to provide a method of manufacturing a functional film by which a functional film formed through a high temperature process can be provided on a desired substrate. Furthermore, a third purpose of the present invention is to provide a structure for functional film pattern formation to be used in a manufacturing process of such a functional film.

In order to accomplish the purposes, a structure for functional film pattern formation according to one aspect of the present invention includes the features of claim 1.

A method of manufacturing a function film according to one aspect of the present invention includes the steps of claim 18.

Here, "reaction" refers to a process in which, from one material or material system, another material or material system different from the initial material or material system in composition or structure is produced. And "reaction" includes a process in which one kind of compound changes into two or more kinds of simpler materials, and a process in which, based on two kinds of materials including at least one kind of compound, two or more kinds of materials different from the initial materials are produced. Further, the former case is specifically referred to as "decomposition" , and the decomposition brought about by heating is referred to as "thermal decomposition".

According to the present invention, the functional film is formed on the substrate in which the pattern has been formed in advance, and thereby, the process of performing dry etching or wet etching on the functional film can be omitted. Although sometimes damage is caused to the functional film in the etching step depending on the materials, such damage is not caused according to the present invention. Further, the functional film is formed on the substrate via the separation layer, and therefore, by applying heat, an electromagnetic wave or an external force to the layer to be peeled, the substrate and the functional film can be easily peeled, or the bonding strength between them is reduced such that they can be dynamically and easily peeled at the subsequent step. Accordingly, the fine functional film pattern formed through the high temperature process can be easily transferred to a flexible substrate, for example, having relatively low heat tolerance and utilized. Therefore, elements having advantageous properties can be suitably mounted on instruments according to application and the performance of the entire instruments utilizing such elements can be improved.

**BRIEF DESCRIPTION OF THE DRAWINGS**

Advantages and features of the present invention will be apparent by considering the following detailed description and the drawings in relation. In these drawings, the same reference numerals indicate the same component elements.

Fig. 1 is a flowchart showing a method of manufacturing a functional film according to the first to third embodiments of the present invention.
Figs. 2A to 2F are sectional views for explanation of the method of manufacturing a functional film according to the first embodiment of the present invention.
Figs. 3A to 3C are sectional views for explanation of the method of manufacturing a functional film according to the second embodiment of the present invention.
Figs. 4A and 4B are sectional views for explanation of a modified example of the method of manufacturing a functional film according to the second embodiment of the present invention.
Figs. 5A to 5C are sectional views for explanation of the method of manufacturing a functional film according to an example not covered by the present invention.
Fig. 6 is a sectional view showing a modified example of a structure for functional film pattern formation.
Fig. 7 is a sectional view showing another modified example of the structure for functional film pattern formation.

**BEST MODE FOR CARRYING OUT THE INVENTION**

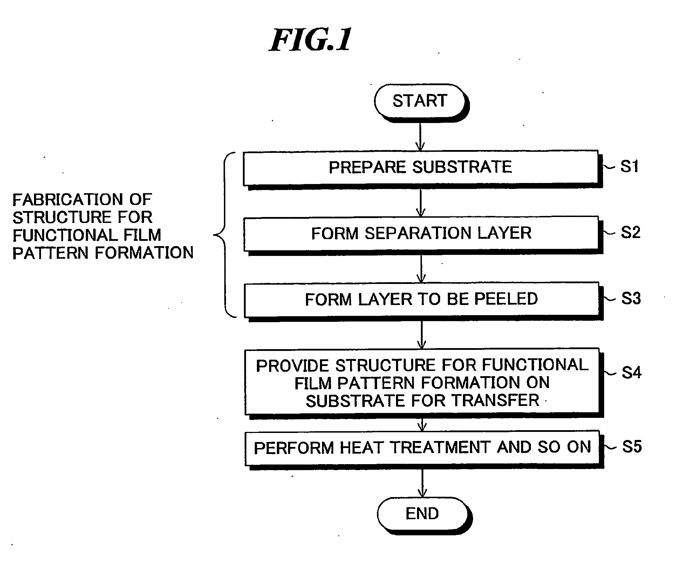

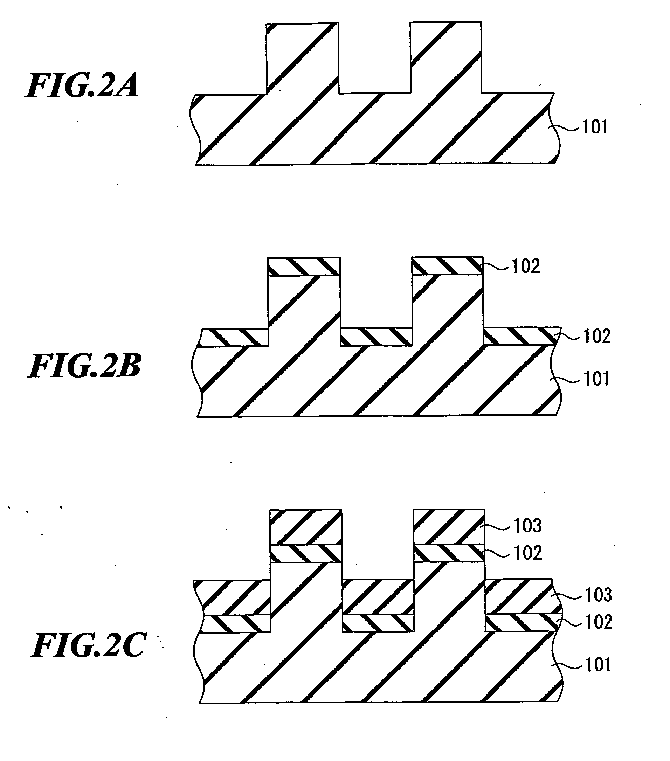

Fig. 1 is a flowchart showing a method of manufacturing a functional film according to the first to third embodiments of the present invention . Further, Figs. 2A to 2F are diagrams for explanation of the method of manufacturing a functional film according to the first embodiment of the present Invention in which Figs. 2A to 2C show steps of fabricating a structure for functional film pattern formation according to the first embodiment of the present invention.

First, at step S1 in Fig. 1, a substrate (mold) 101, in which apatternhavingprojections and depressions is formed, is prepared as shown in Fig. 2A. In the substrate, the projecting portions correspond to a pattern to be formed in a functional film as a target of manufacturing.

As a material of the substrate 101, a single crystal material including a semiconductor single crystal material and an oxide single crystal material, a ceramics material, a glass material, or a metal material may be used. The substrate material is selected in consideration of heat tolerance or the like to a process temperature in the film formation process when the functional film is formed and the heat treatment process performed according to need.

As an oxide single crystal material, specifically, magnesium oxide (MgO), alumina ($Al_2O_3$) , titanium oxide ($TiO_2$) , zinc oxide (ZnO), spinel (magnesium aluminate, $MgAl_2O_4$), strontium titanate ($SrTiO_3$) , lanthanum aluminate ($LaAlO_3$) , lithium niobate ($LiNbO_3$) , lithium tantalate ($LiTaO_3$) and so on are cited. In the case where the oxide single crystal material is used, by selecting a material having a predetermined lattice constant according to a functional film as a target of manufacturing, the functional film can be formed by epitaxial growth. Further, since these materials are stable in an oxidizing atmosphere, they can be used for film formation or heat-treated at high temperature (e.g., about 1000°C for magnesium oxide) in the air atmosphere.

As a semiconductor single crystal material, specifically, silicon (Si), germanium (Ge), gallium arsenide (GaAs), gallium phosphide (GaP), indium phosphide (InP) and so on are cited. In the case where the semiconductor single crystal material is used, by selecting a material having a predetermined lattice constant according to a functional film as a target of manufacturing, the functional film can be formed by epitaxial growth. Further, since these materials are stable in a reducing atmosphere, they can be used for film formation or heat-treated at high temperature (e.g., about 1000°C for silicon) in the reducing atmosphere.

As a ceramics material, alumina ($Al_2O_3$), zirconia ($ZrO_2$), aluminum nitride (AlN) and so on are cited. Since the ceramics material is more inexpensive than the single crystal material, the cost of manufacturing can be reduced. Further, since these materials are stable in the air atmosphere and have high heat tolerance, they can be used for film formation or heat-treated at high temperature (e.g., about 1100°C for alumina) in the air atmosphere.

As a glass material, specifically, silicate glass, alkaline silicate glass, borosilicate glass, soda-lime glass, lead glass and so on are cited. Since the glass material is more inexpensive than the single crystal material, the cost of manufacturing can be reduced. Further, since these materials are stable in an oxidizing atmosphere, they can be used for film formation or heat-treated at high temperature (e.g., about 900°C for silicate glass) in the air atmosphere.

As a metal material, specifically, metal such as platinum (Pt), copper (Cu), nickel (Ni), iron (Fe) and so on, and alloy such as stainless steel are cited. Since the metal material is more inexpensive than the single crystal material, the cost of manufacturing can be reduced. Further, since these materials are stable in a reducing atmosphere, they can be used for film formation or heat-treated at high temperature (e.g., about 1000°C for platinum) in the reducing atmosphere.

The substrate 101 can be fabricated by forming a pattern in a substrate made of the above-mentioned material by using dry etching, electron beam lithography or the like. In this regard, for example, a mold fabrication technology used in nanoimprint technology may be applied. Alternatively, a commercially available nanoimprint mold may be used.

Next, at step S2, a separation layer 102 is formed on the substrate 101, as shown in Fig. 2B. The separation layer 102 is a sacrifice layer that is removed when a functional film to be formed at the subsequent step is peeled from the substrate 101. As a material of the separation layer 102, a material that induces a reaction of thermal decomposition or the like by being heated to generate a gas is used. Specifically, a compound containing at least one of carbonates of magnesium carbonate ($MgCO_3$, decomposed at about 600°C), calcium carbonate ($CaCO_3$, decomposed at about 900°C), strontium carbonate ($SrCO_3$, decomposed at about 900°C), barium carbonate ($BaCO_3$, decomposed at about 1450°C), lithium carbonate ($LiCO_3$, decomposed at about 618°C), sodium carbonate ($Na_2CO_3$), potassium carbonate ($K_2CO_3$) and so on, a compound containing at least one of sulfates of magnesium sulfate ($MgSO_4$, decomposed at about 1185°C), calcium sulfate ($CaSO_4$, decomposed at about 1000°C), strontium sulfate ($srSO_4$, decomposed at about 1130°C), barium sulfate ($BaSO_4$, decomposed at about 1200°C), ferrous sulfate ($FeSO_4$), cobalt sulfate ($CoSO_4$), nickel sulfate ($NiSO_4$), zinc sulfate ($ZnSO_4$), lead sulfate ($PbSO_4$), bismuth sulfate ($Bi(SO_4)_3$) and so on, and a compound containing at least one of nitrates of strontium nitrate ($Sr(NO_3)_2$, cesium nitrate ($C_SNO_3$) and so on are used. These compounds are, decomposed by being applied with an electromagnetic wave having a predetermined wavelength to generate gases. For example, by heating calcium carbonate, decomposition reaction ($CaCO_3 \rightarrow CaO + CO_2\uparrow$) occurs and carbon dioxide ($CO_2$) is generated.

Alternatively, metal nitride containing at least one element of Ti, V, Cr, Mn, Fe, Co, Ni, Ga (gallium nitride is decomposed at about 900°C), Zr, Mo (molybdenum nitride is decomposed at about 900°C), Ta and W, metal sulfide containing at least one element of V, Cr, Mn, Fe, Co, Ni, Mo, Ta and W, and metal carbide such as TiC may be used. These compounds are applied with an electromagnetic wave having a predetermined wavelength to react with components in the atmosphere or an adjacent layer, i.e., components contained in the substrate 101 or a layer to be peeled 103, which will be described later, to generate a gas. For example, in the case where a substrate containing oxide and a separation layer containing metal nitride are used, the separation layer reacts with the oxide to generate nitrogen ($N_2$).

As a method of forming the separation layer, a known method such as spin coating, sputtering and CVD (chemical vapor deposition) methods may be used.

Next, at step S3, a layer to be peeled 103 containing a material of a functional film as a target of manufacturing (functional material) is formed on the separation layer 102, as shown in Fig. 2C. The layer to be peeled 103 is formed by using a known method such as a sputtering method, a CVD method, a sol-gel method and an aerosol deposition (AD) method. Here, the AD method is a film forming method of generating an aerosol in which raw material powder is dispersed in a gas, injecting the aerosol from a nozzle toward a substrate to allow the raw material powder to collide with the under layer, and thereby, depositing the raw material on the substrate, and the method is also called "injection deposition method" or "gas deposition method".

In the embodiment, specifically, the following materials are used as functional materials.

As a material of a functional film to be used for a memory element, Pb (Zr,Ti) $O_3$, $SrBi_2(Ta,Nb)_2O_9$, $Bi_4Ti_3O_{12}$ and so on are cited.

As a material of a functional film to be used for a piezoelectric element such as an actuator, $Pb(Zr,Ti)O_3$, $Pb(Mg_{1/3}Nb_{2/3})O_3$, $Pb(Zn_{1/3}Nb_{2/3})O_3$, $Pb(Ni_{1/3}Nb_{2/3})O_3$ and so on, and solid solutions thereof are cited.

As a material of a functional film to be used for a pyroelectric element such as an infrared sensor, Pb (Zr, Ti) $O_3$, (Pb,La) (Zr,Ti)$O_3$ and so on are cited.

As a material of a functional film to be used for a passive component such as a capacitor, BaSrTiO$_3$, (Pb,La) (Zr,Ti)$O_3$ and so on are cited.

As a material of a functional film to be used for an optical element such as an optical switch, (Pb,La) (Zr,Ti)$O_3$, LiNbO$_3$ and so on are cited.

As a material of a functional film to be used for a superconducting element such as a superconducting quantum interference device (SQUID) , YBa$_2$Cu$_3$O$_7$, Bi$_2$Sr$_2$Ca$_2$Cu$_3$O$_{10}$ and so on are cited. Here, SQUID refers to a highly sensitive magnetic sensor element utilizing superconductivity.

As a material of a functional film to be used for a photoelectric conversion element such as a solar cell, amorphous silicon and compound semiconductor are cited.

As a material of a functional film to be used for a micro magnetic element such as a magnetic head, PdPtMn, CoPtCr and so on are cited.

As a material of a functional film to be used for a semiconductor element such as a TFT, amorphous silicon and so on are cited.

The structure for functional film pattern formation according to the embodiment includes the substrate 101, the separation layer 102 and the layer to be peeled 103 formed at those steps S1 to S3.

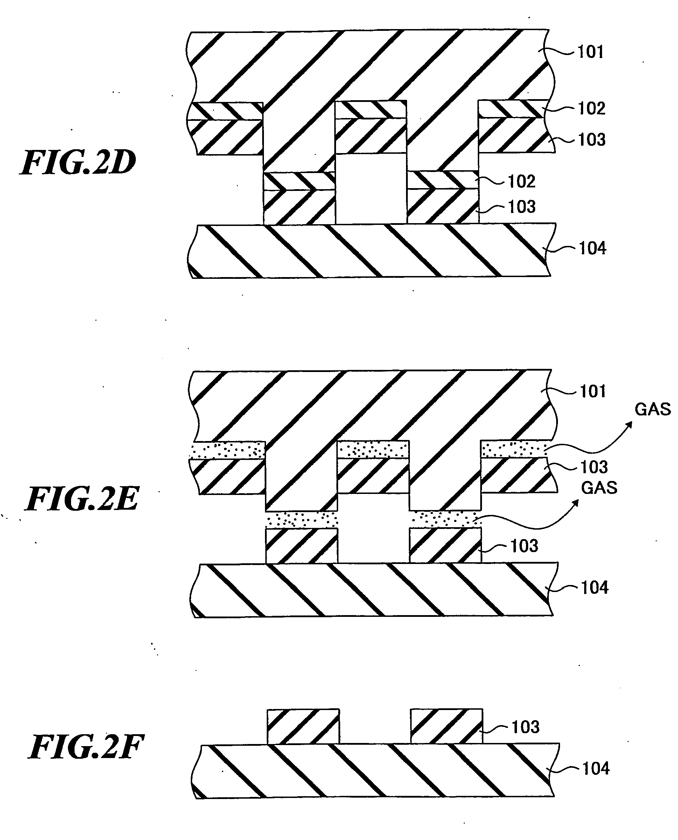

Next, at step S4 , a substrate for transfer 104 is prepared, and the structure for functional film pattern formation 101 to 103 is provided and fixed such that the layer to be peeled 103 faces the substrate for transfer 104, as shown in Fig. 2D. In this regard, the layer to be peeled 103 and the substrate for transfer 104 may be fixed to each other by using an adhesive agent or the like. As the substrate for transfer 104, a desired substrate such as a synthesized resin substrate of epoxy or the like or glass substrate may be used. Further, electrodes and interconnections may be formed at the substrate for transfer 104 side in advance.

Next, at step S5, heat treatment is performed on the structure for functional film pattern formation 101 to 103. The temperature of the heat treatment is set to the same level with the reaction temperature of the separation layer 102 or more in order to cause the reaction such as thermal composition or the like in the separation layer 102 . Thereby, as shown in Fig. 2E, reaction such as thermal decomposition occurs in the separation layer 102 and a gas is generated. As a result, as shown in Fig. 2F, the layer to be peeled 103 is peeled from the substrate 101 and transferred to the substrate for transfer 104. Alternatively, the bonding strength between the layer to be peeled 103 and the substrate 101 becomes lower as a result of generating the gas, and thereby, the layer to be peeled 103 can be dynamically and easily peeled form the substrate 101. In this case, the layer to be peeled 103 can be transferred by peeling the substrate for transfer 104 at the same time as heating or at the subsequent step.

Further, at step S5, heat treatment (post anneal) for promoting grain growth in the functional film or improving crystallinity to improve the function of the film may be performed. For example, in the case of manufacturing a functional film of Pb (Zr,Ti)O$_3$, (Pb, La) (Zr,Ti)O$_3$, BaSrTi$_3$ or the like, heat treatment is performed at temperature of 500°C or more. Further, in the case of manufacturing a functional film of SrBi$_2$(Ta,Nb)$_2$O$_9$, Bi$_4$Ti$_3$O$_{12}$, YBa$_2$Cu$_3$O$_7$, Bi$_2$Sr$_2$Ca$_2$Cu$_3$O$_{10}$ or the like, heat treatment is performed at temperature of 700°C or more. In this case, it is necessary to select the materials of the substrate for transfer 104 and adhesive agent in consideration of heat tolerance to the heat treatment temperature.

As described above, according to the first embodiment of the present invention, since the separation layer is provided between the substrate and the functional film, the functional film can be peeled from the substrate by heat treatment or they can be made easier to be peeled by reducing the bonding strength between them. Accordingly, a high-performance functional film fabricated by a film formation technology can be provided in a desired pattern on a desired substrate. Further, since the heat treatment process and the peeling (transfer) process can be performed at the same time by selecting the appropriate separation layer material according to the heat treatment temperature and heat treatment atmosphere for the functional film, the manufacturing process becomes simpler and the cost of manufacturing can be reduced.

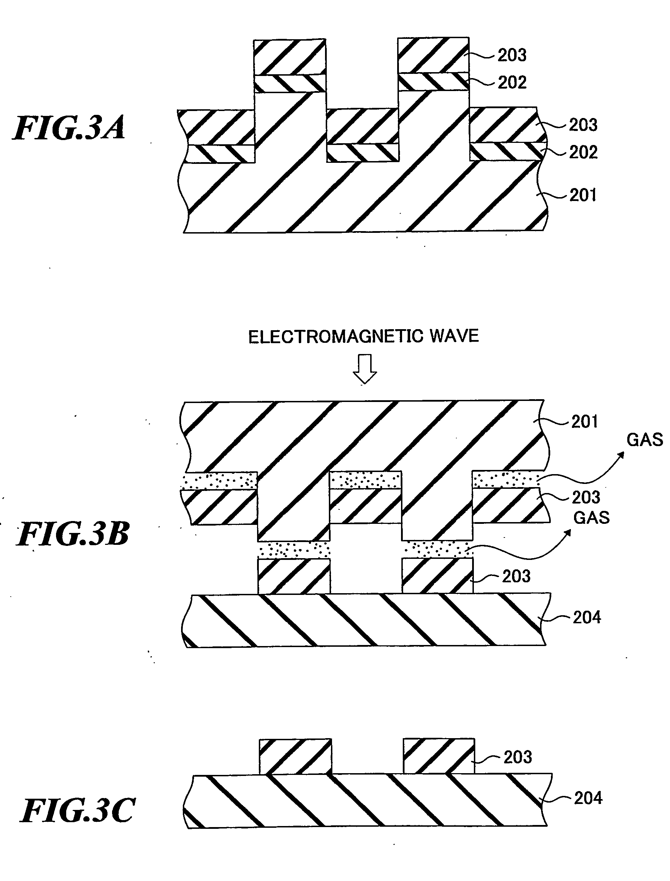

Next, a method of manufacturing a functional film according to the second embodiment will be explained by referring to Figs. 1 and 3A to 3C. Figs. 3A to 3C are sectional views for explanation of the method of manufacturing a functional film according to the embodiment. The method of manufacturing a functional film according to the embodiment is characterized in that an electromagnetic wave is used at the step (S5) of peeling the layer to be peeled from the substrate.

First, at steps S1 to S3 of Fig. 1, a structure for functional film pattern formation 201 to 203 including a substrate 201, a separation layer 202 and a layer to be peeled 203 is fabricated, as shown in Fig. 3A.

As the material of the substrate 201, suitable one is selected from a single crystal material including a semiconductor single crystal material and an oxide single crystal material, a ceramics material and a glass material according to a wavelength of the electromagnetic wave to be used and so on. For example, in the case where light such as ultraviolet is used at step S5, it is desired to use a substrate through which a predetermined wavelength component is propagated or transmitted. Unlike the first embodiment, a metal material is not very preferable because it reflects almost all electromagnetic waves. Further, it is desirable that heat tolerance to process temperature in the film formation process and the heat treatment process performed according to need is also considered.

As a material of the separation layer 202, a material is used that causes, by being applied with an electromagnetic wave, reaction such as thermal decomposition or the like to generate a gas. Further, it desirably has heat tolerance to about 350°C or more in consideration of process temperature in the film formation process or the like. Specifically, similarly to those as explained in the first embodiment, a compound containing carbonate, sulfate or nitrate, or a metal compound such as metal nitride, metal sulfide or metal carbide is used. The former decomposes to generate a gas by being applied with an electromagnetic wave having a predetermined wavelength. Further, the latter reacts with a component in an atmosphere or a material contained in an adjacent layer, i.e., the substrate 201 or the layer to be peeled 203, which will be describe later, to generate a gas by being applied with an electromagnetic wave having a predetermined wavelength.

The material of the layer to be peeled 203 is the same as that has explained in the first embodiment. Further, the method of fabricating the substrate 201 and the methods of forming the separation layer 202 and the layer to be peeled 203 are also the same as those have been explained in the first embodiment. Subsequently, heat treatment for improving the function of the function film may be performed on the structure for functional film pattern formation 201 to 203 according to need.

Next, at step S4 in Fig. 1, a substrate for transfer 204 is prepared, and the structure for functional film pattern formation 201 to 203 is provided and fixed such that the layer to be peeled 203 faces the substrate for transfer. In this regard, the layer to be peeled 203 and the substrate for transfer may be fixed to each other by using an adhesive agent or the like. As the substrate for transfer 204, a desired substrate such as a synthesized resin substrate of epoxy or the like or glass substrate may be used. Further, electrodes and interconnections may be formed at the substrate for transfer side in advance.

Next, at step S5, an electromagnetic wave is applied to the structure for functional film pattern formation 201 to 203. Thereby, as shown in Fig. 3B, reaction such as decomposition occurs in the separation layer 202 and a gas is generated. As a result, the layer to be peeled 203 is peeled from the substrate 201 and the layer to be peeled 203 is transferred to the substrate for transfer 204 as shown in Fig. 3C. Alternatively, the bonding strength between the layer to be peeled 203 and the substrate 201 becomes lower as a result of generating the gas, and thereby, the layer to be peeled 203 can be dynamically and easily peeled form the substrate 201. In this case, the layer to be peeled 203 can be transferred by peeling the substrate for transfer 204 at the same time as application of an electromagnetic wave or at the subsequent step.

As the electromagnetic wave, an electromagnetic wave capable of causing the reaction such as deposition in the separation layer 202 is selected among a microwave, an infrared ray, a visible ray, an ultraviolet ray and an X-ray. Here, the microwave is an electromagnetic wave having a wavelength of about 1m to 1mm, and includes UHF wave (decimeter wave) , SHF wave (centimeter wave) , EHF wave (millimeter wave) and submillimeter wave.

For example, in the case where an infrared ray containing an absorption wavelength of the separation layer material is applied to the separation layer 202, molecules contained in the separation layer material absorb infrared energy to greatly vibrate, and consequently, reaction such as decomposition occurs in the separation layer. Specifically, the case where an infrared ray having a wavelength of about $6.8\mu m$ or $11.6\mu m$ is applied to calcium carbonate is cited. Further, in the case where an ultraviolet ray containing a component having the absorption wavelength of the separation layer material is applied to the separation layer 202, atoms contained in the separation layer material absorb ultraviolet energy and outer electrons transition and become activated, and consequently, reaction such as decomposition occurs in the separation layer. Specifically, the case where an ultraviolet ray having a wavelength of about 248nm is applied to calcium carbonate is cited. In this case, there is an advantage that the substrate 201 and the layer to be peeled 203 are not affected by heat. In the case where light such as an infrared or ultraviolet ray is used, it is desired that the electromagnetic wave is applied from the substrate 201 side toward the separation layer 202 as shown in Fig. 3B. Alternatively, an electromagnetic wave may be applied toward the side surface of the structure for functional film pattern formation.

By the way, in the case where a microwave is applied to the separation layer 202, the separation layer 202 generates heat and reaction occurs according to the principle of microwave heating. Here, the absorption energy P of the microwave is expressed by the following equation (1).

$$P = (1/2)\sigma|E|^2 + \pi f \varepsilon_0 \varepsilon_r''|E|^2 + \pi f \mu_0 \mu_r''|H|^2 \quad \ldots (1)$$

In equation (1), $\sigma$ represents an electric conductivity, f (Hz) represents a frequency of the microwave, $\varepsilon_0$ represents a dielectric constant of vacuum, $\varepsilon_r''$ represents a relative dielectric constant (complex) , $\mu_0$ represents a permeability of vacuum, $\mu_r''$ represents a relative permeability (complex) , E represents an electric field intensity, and H represents a magnetic field intensity. Further, the first term of the equation (1) represents joule loss (resistance loss), the second term represents dielectric loss, and the third item represents magnetic hysteresis loss.

When an electromagnetic field is applied by applying a microwave to the separation layer 102, heat corresponding to energy expressed by the equation (1) is generated. As a result, reaction such as decomposition occurs in the separation layer 102. Therefore, in the case of using a microwave, in order to efficiently generate heat, it is desired that a material having a large relative dielectric constant (complex) $\varepsilon_r''$ , a material having a large relative permeability

(complex) $\mu_r''$, or a material having a large electric conductivity $\sigma$ is used as the separation layer 102.

According to the principle of microwave heating, the electromagnetic wave absorbing layer 202 is rapidly and uniformly heated to the interior thereof by being applied with microwave. Accordingly, reaction such as decomposition is quickly caused in the separation layer 202, and the layer to be peeled 203 can be peeled from the substrate 201 in a short period of time, or the bonding strength of them can be reduced. Further, while the microwave is applied, only the region applied with the microwave is locally heated, and when the application of microwave is stopped, the region is rapidly cooled, and therefore, the influence on other layers (e.g., the layer to be peeled 203 and the substrate for transfer 204) can be minimized. In the case of using a microwave, the microwave can reach the interior of the functional film containing structure without especially limiting an orientation of the microwave to be applied to the functional film containing structure.

(Example 1)

First, a quartz mold is fabricated. For the purpose, a resist is applied to a quartz substrate, and exposure to light and development are performed, and thereby, a resist pattern is formed. Then, a pattern is formed on the quartz substrate by dry etching by using the resist pattern as a mask. Furthermore, ashing (resist peeling) is performed.

On the thus fabricated quartz mold, a tantalum nitride (TaN) film having a thickness of about $0.1\mu m$ is formed as a separation layer by using a PLD (pulse laser deposition) method. A lower electrode of platinum (Pt) is formed on the tantalum nitride film by using the sputtering method, and a BST (barium strontium titanate) film having a thickness of about 200nm is formed thereon by using the PLD method. At this time, the substrate temperature is heated to about 550°C. Furthermore, an upper electrode of platinum is formed on the BST film by using the sputtering method, and thereby, a Pt/BST/Pt thin film capacitor is fabricated.

Then, an adhesive agent is applied onto the upper electrode of the Pt/BST/Pt thin film capacitor formed on the projecting portions of the mold, and bonded to an epoxy substrate for transfer. Furthermore, when a KrF excimer laser beam (wavelength 248nm) is applied from the rear side of the mold toward the tantalum nitride film, the tantalum nitride film reacts and generates a gas. Thereby, the Pt/BST/Pt thin film capacitor is peeled from the mold and transferred to the substrate for transfer.

As described above, according to the second embodiment of the present invention, the functional film can be easily peeled from the substrate or the bonding strength between them can be reduced for easy peeling at relatively low temperature (about 10°C to about 100°C) by applying an electromagnetic wave to the separation layer. Therefore, an element containing a functional film formed by using the film formation technology such as the evaporation method and the AD method through predetermined process temperature (e.g., about 350°C or more) or a functional film provided with a high function by heat treatment at high temperature (e.g., about 800°C) can be easily transferred to a desired substrate and utilized. That is, the transfer can be performed to a resin substrate having relatively low heat tolerance, and therefore, the range of choices of substrates can be expanded to a flexible substrate, for example, according to application.

In the embodiment, at the transfer step (step S5 in Fig. 1) , an electromagnetic wave may be applied while heating the structure for functional film pattern formation. Thereby, the reaction in the separation layer 202 can be promoted, and the layer to be peeled 203 can be peeled from the substrate 201 or the bonding strength between them can be reduced in a shorter time or with a weaker electromagnetic wave. In addition, the effect of improving the function of the functional film is expected by adjusting the heat treatment temperature according to the material of the functional film.

Next, a modified example of the method of manufacturing a functional film according to the second embodiment of the present invention will be explained.

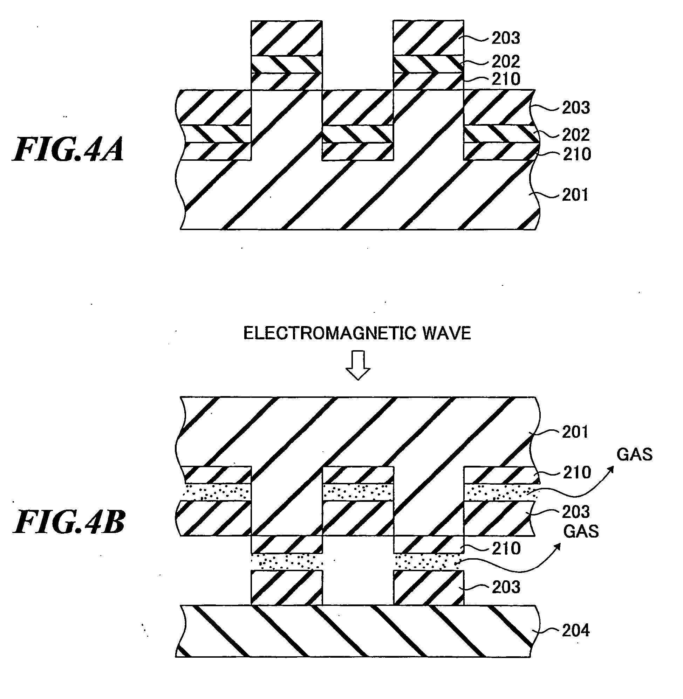

In the modified example, as shown in Fig. 4A, an electromagnetic wave absorbing layer 210 is further formed between the substrate 201 and the separation layer 202. The electromagnetic wave absorbing layer 210 is a layer that absorbs, when an electromagnetic wave is applied, the electromagnetic energy thereof to generate heat. Specifically, it is formed by carbon, ceramics, glass or the like. The material of the electromagnetic wave absorbing layer 210 is desirably determined according to an electromagnetic wave to be used in the subsequent step (an electric wave including a microwave, or an infrared ray, etc.) .

Such a structure for functional film pattern formation is provided on the substrate for transfer 204, and the electromagnetic wave is applied toward the electromagnetic wave absorbing layer 210. Thereby, as shown in Fig. 4B, the adjacent separation layer 202 is heated by the electromagnetic wave absorbing layer 210 which is generating heat, reaction such as decomposition occurs in the separation layer 202, and a gas is generated. As a result, the layer to be peeled 203 is peeled from the substrate 201 and transferred to the substrate for transfer 204. Alternatively, the bonding strength between the layer to be peeled 203 and the substrate 201 or the electromagnetic wave absorbing layer 210 becomes lower as a result of generating the gas, and thereby, the layer to be peeled 203 can be transferred by peeling the substrate for transfer 204 at the same time as the application of an electromagnetic wave or at the subsequent step.

According to the modified example, even in the case where the separation layer itself has little sensitivity to an electromagnetic wave, that is, its reactivity to an electromagnetic wave is not high, reaction because of heat can be produced in the separation layer. Therefore, the range of choices of kinds (wavelengths) of electromagnetic waves and separation layer materials can be expanded.

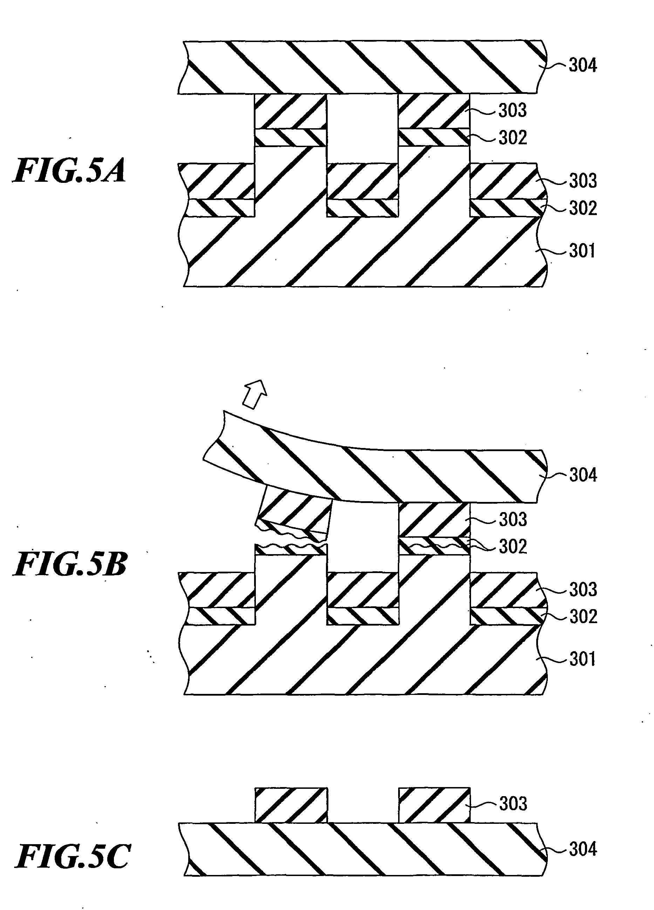

Next, a method of manufacturing a functional film according to an example not covered by the present invention will be explained by referring to Figs. 1 and 5A to 5C. Figs. 5A to 5C are diagrams for explanation of the method of manufacturing a functional film according to the embodiment. The method of manufacturing a functional film according to the embodiment is characterized in that a physical and external force is used at the step (step S5) of peeling the layer to be peeled from the substrate.

First, as shown in Fig. 5A, a structure for functional film pattern formation 301 to 303 including a substrate 301, a separation layer 302, and a layer to be peeled 303 is fabricated (steps S1 to S3 in Fig. 1), and a substrate for transfer 304 is provided and fixed (step S4 in Fig. 1).

As the material of the substrate 301, a single crystal substrate including a semiconductor single crystal substrate and an oxide single crystal substrate, a ceramic substrate, a glass substrate or a metal substrate as those have been cited in the first embodiment may be used, and a material having heat tolerance to a process temperature in the film formation process when the functional film is formed and heat treatment process performed according to need is selected among them.

As the material of the separation layer 302, a material that easily fractures by being applied with an external force like a material having cleavage characteristics is used. Further, in consideration of process temperature at the subsequent process (e.g. , about 350°C or more) , it is desired that a material having heat tolerance is used. As such a material, hexagonal boron nitride (h-BN), mica, graphite, transition metal chalcogenide including molybdenum disulfide ($MoS_2$) and so on are cited. Further, as a method of forming the separation layer 302, a known method such as sputtering and CVD (chemical vapor deposition) methods may be used.

The material of the layer to be peeled 303 is the same as that has explained in the first embodiment. Further, the method of fabricating the substrate 301 and the method of forming the layer to be peeled 303 are also the same as those have been explained in the first embodiment.

As the substrate for transfer 304, a substrate having a certain degree of elasticity such as a synthesized resin substrate of epoxy or the like is desirably used. Further, electrodes and interconnections maybe formed at the substrate for transfer 304 side in advance. Furthermore, the layer to be peeled 303 and the substrate for transfer 304 may be fixed using an adhesive agent or the like.

Next, at step S5, an external force is applied to the separation layer 302. As a method of applying an external force, the substrate for transfer 304 may be relatively displaced or deformed to the separation layer 302. Specifically, as shown in Fig. 5B, the substrate for transfer 304 may be peeled from the substrate 301, or the substrate for transfer 304 may be pulled in the horizontal direction relative to the substrate 301. Thereby, fracture is produced within the separation layer 302 or at an interface thereof, and the layer to be peeled 303 is peeled from the substrate 301 and transferred to the substrate for transfer 104 as shown in Fig. 5C. Alternatively, the bonding strength between the layer to be peeled 303 and the substrate 301 becomes lower by applying an external force, and thereby, the layer to be peeled 303 may be transferred by further pulling up the substrate for transfer 304.

(Example 2)

First, a quartz mold is fabricated. For the purpose, a resist is applied to a quartz substrate, and a resist pattern is formed by performing exposure to light and development. Then, a pattern is formed on the quartz substrate by dry etching by using the resist pattern as a mask. Furthermore, ashing (resist peeling) is performed.

On the thus fabricated quartz mold, a hexagonal boron nitride (h-BN) film having a thickness of about 0.2$\mu$m is formed as a separation layer by using a reactive sputtering method. A lower electrode of platinum (Pt) is formed on the hexagonal boron nitride film by using the sputtering method, and a BST (barium strontium titanate) film having a thickness of about 200nm is formed thereon by using the PLD method. At this time, the substrate is heated to a temperature of about 550°C. Furthermore, an upper electrode of platinum is formed on the BST film by using the sputtering method, and thereby, a Pt/BST/Pt thin film capacitor is fabricated.

Then, an adhesive agent is applied onto the upper electrode of the Pt/BST/Pt thin film capacitor formed on the projecting portions of the mold, and bonded to an epoxy substrate for transfer. Furthermore, when the mold is fixed and an external force is applied to the hexagonal boron nitride film by pulling up the substrate for transfer, fracture is produced in the film. Thereby, the Pt/BST/Pt thin film capacitor is peeled from the mold and transferred to the substrate for transfer.

As described above, according to this example, the functional film can be easily peeled from the film formation substrate or the bonding strength between them can be reduced for easy peeling by applying an external force to the separation layer. At that time, temperature never rises not only outside of the structure for functional film pattern formation but also inside thereof, and the functional film and the element containing the functional film can be transferred to a resin substrate having relatively low heat tolerance and utilized.

Further since the material of the separation layer 302 to be used in this example has relatively high heat tolerance, heat treatment can be performed on the functional film at a high temperature before the layer to be peeled 304 is provided. For example, h-BN is stable in an oxygen atmosphere and has heat tolerance to about 800°C to 1000°C. Accordingly, in the case where a PZT film is fabricated by using h-BN as the separation layer, the piezoelectric property of the PZT film can be improved by performing heat treatment at about 800°C, for example.

As a modified example of the method of manufacturing a functional film, an external force may be applied to the separation layer 302 while heating the structure for functional film pattern formation. Thereby, fracture is easily produced in the separation layer 302, and the layer to be peeled 303 can be peeled with weaker force. In this regard, improvement in the function of the functional film is expected by adjusting the heat treatment temperature according to the material of the functional film. In this case, the materials of the substrate for transfer -304 and adhesive agent are desirably selected according to the heat treatment temperature.

Alternatively, as another modified example, an external force may be applied to the separation layer 302 while applying an electromagnetic wave to the structure for functional film pattern formation. For example, since the material contained in the separation layer 302 is activated by being applied with an ultraviolet ray and the separation layer 302 is heated by being applied with an infrared ray or a microwave, fracture can be produced in the separation layer 302 with weaker force. In the case of applying light such as an ultraviolet ray and an infrared ray, it is desired to use a substrate material that is transparent to the electromagnetic wave to be used and the electromagnetic wave is applied from the rear side of the substrate 301 toward the separation layer 302.

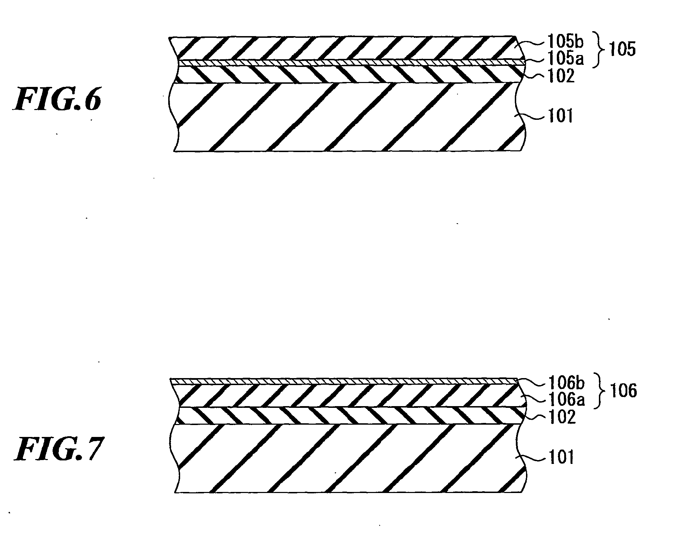

As a modified example of the structure for functional film pattern formation to be used in the manufacturing process of the functional film according to the first and second embodiments of the present invention, at least one electrode may be formed on an upper surface or a lower surface of the functional film. For example, as shown in Fig. 6, a layer to be peeled 105 including an electrode layer 105a and a functional material layer 105b may be formed, or, as shown in Fig. 7, a layer to be peeled 106 including a functional material layer 106a and an electrode layer 106b may be formed. Further, a layer to be peeled including electrode layers on both of upper and lower surfaces of the functional material layer may be used. The electrode layers 105a and 106b may be formed by using a known method such as a sputtering method and an evaporation method.

Further, in the embodiments, the layer to be peeled has been transferred to the substrate for transfer at the same time as being peeled from the substrate. However, only the peeling of the layer to be peeled may be performed without using the substrate for transfer. Thereby, a functional film molded in a desired shape in advance, or a functional element containing a functional film and an electrode can be obtained. In addiction, in the case where a material having cleavage characteristics is used as the separation layer, an external force may be applied to the separation layer by applying physical stimulation (e.g., impact) to the side surface of the separation layer or the like.

The substrate (101, 201, 301) to be used in the above-mentioned embodiments can be reused by removing the residual separation layer by cleansing, etching or the like after peeling the layer to be peeled. Therefore, a number of the substrates can be suppressed and the cost of manufacture can be reduced.

## INDUSTRIAL APPLICABILITY

The present invention can be applied to memory elements, piezoelectric elements, pyroelectric elements, passive elements such as capacitors, optical elements, superconducting elements, photoelectric conversion elements, micromagnetic elements and semiconductor elements containing functional materials such as dielectric materials, piezoelectric materials, pyroelectric materials, magnetic material and semiconductor materials, and instruments to which those elements are applied.

## Claims

1. A structure for functional film pattern formation comprising:

   a substrate (101, 201) in which a predetermined pattern is formed;
   a separation layer (102, 202) directly or indirectly provided on said substrate (101, 201); and
   a layer to be peeled (103, 105, 106, 203) provided on said separation layer (102, 202) and containing a functional film (103, 105b, 106a, 203) formed by using a functional material; **characterized in that**:
   said layer to be peeled (103, 105, 106, 203) is peeled from said substrate (101, 201) or bonding strength between said layer to be peeled (103, 105, 106, 203) and said substrate (101, 201) becomes lower as a result of generating a gas from said separation layer (102, 202) by one of heating said separation layer (102) and applying an electromagnetic wave toward said separation layer (202).

2. A structure for functional film pattern formation according to claim 1, wherein said separation layer (102) contains an inorganic material which is decomposed to generate a gas by being heated.

3. A structure for functional film pattern formation according to claim 1, wherein said separation layer (202) contains an inorganic material which is decomposed to generate a gas by being applied with an electromagnetic wave.

4. A structure for functional film pattern formation according to claim 2 or 3, wherein said separation layer (102, 202) contains at least one of carbonate, sulfate and nitrate.

5. A structure for functional film pattern formation according to claim 4, wherein said separation layer (102, 202) contains at least one of magnesium carbonate ($MgCO_3$) , calcium carbonate ($CaCO_2$), strontium carbonate ($SrCO_3$), barium carbonate ($BaCO_3$) , lithium carbonate ($LiCO_2$) , sodium carbonate ($Na_2CO_3$), potassium carbonate ($K_2CO_3$) , magnesium sulfate ($MgSO_4$) , calcium sulfate ($CaSO_4$), strontium sulfate ($SrSO_4$), barium sulfate ($BaSO_4$), iron sulfate ($FeSO_4$), cobalt sulfate ($C_OSO_4$), nickel sulfate ($NiLSO_4$), zinc sulfate ($ZnSO_4$), lead sulfate ($PbSO_4$), bismuth sulfate ($Bi(SO_4)_3$), strontium nitrate ($Sr(NO_3)_2$) and cesium nitrate ($CsNO_3$) .

6. A structure for functional film pattern formation according to claim 1, wherein said separation layer (102) contains an inorganic material which reacts with one of a component in an atmosphere and a component contained in an adjacent layer to generate a gas by being heated.

7. A structure for functional film pattern formation according to claim 1, wherein said separation layer (202) contains an inorganic material which, reacts with one of a component in an atmosphere and a component contained in an adjacent layer to generate a gas by being applied with an electromagnetic wave.

8. A structure for functional film pattern formation according to claim 6 or 7, wherein said separation layer (102, 202) contains at least one of metal nitride, metal carbide and metal sulfide.

9. A structure for functional film pattern formation according to any one of claims 2 to 8, further comprising:

    an electromagnetic wave absorbing layer (210) provided between said substrate (101, 201) and said separation layer (102, 202) and formed by using a material which absorbs an electromagnetic wave to generate heat.

10. A structure for functional film pattern formation according to claim 9, wherein said electromagnetic wave absorbing layer (210) contains one of carbon, ceramics and glass.

11. A structure for functional film pattern formation according to any one of claims 1 to 10, wherein said substrate (101, 201) contains one of a single crystal material, which includes one of an oxide single crystal material and a semiconductor single crystal material, a ceramics material and a glass material.

12. A structure for functional film pattern formation according to any one of claims 2, 6 and 11, wherein said substrate (101, 201) contains a metal material.

13. A structure for functional film pattern formation according to any one of claims 1 to 12, wherein said functional film (103, 105b, 106a, 203) contains at least one of a piezoelectric material, a pyroelectric material and a ferroelectric material.

14. A structure for functional film pattern formation according to any one of claims 1 to 12, wherein said functional film (103, 105b, 106a, 203) contains a superconducting material.

15. A structure for functional film pattern formation according to any one of claims 1 to 12, wherein said functional film (103, 105b, 106a, 203) contains amagneticmaterial.

16. A structure for functional film pattern formation according to any one of claims 1 to 12, wherein said functional film (103, 105b, 106a, 203) contains a semiconductor material.

**17.** A structure for functional film pattern formation according to any one of claims 1 to 16, wherein said layer to be peeled (105, 106) has a functional film (105b, 106a) and at least one electrode layer (105a, 106b) formed on at least one of an upper surface and a lower surface of the functional film (105b, 106a).

**18.** A method of manufacturing a functional film comprising the steps of:

(a) preparing a substrate (101, 201) in which a predetermined pattern is formed;
(b) forming a separation layer (102, 202) directly or indirectly on said substrate (101, 201); and
(c) forming a layer to be peeled (103, 105, 106, 203) containing a functional film (103, 105b, 106a, 203), which is formed by using a functional material, on said separation layer (102, 202); **characterized by**:
(d) peeling said layer to be peeled (103, 105, 106, 203) from said substrate (101, 201) or reducing bonding strength between said layer to be peeled (103, 105, 106, 203) and said substrate (101, 201) as a result of generating a gas from said separation layer (102, 202) by one of heating said separation layer (102) and applying an electromagnetic wave toward said separation layer (202).

**19.** A method of manufacturing a functional film according to claim 18, wherein said separation layer (102) contains an inorganic material which is decomposed to generate a gas by being heated.

**20.** A method of manufacturing a functional film according to claim 18, wherein said separation layer (202) contains an inorganic material which is decomposed to generate a gas by being applied with an electromagnetic wave.

**21.** A method of manufacturing a functional film according to claim 19 or 20, wherein said separation layer (102, 202) contains at least one of carbonate, sulfate and nitrate.

**22.** A method of manufacturing a functional film according to claim 21, wherein said separation layer (102, 202) contains at least one of magnesium carbonate ($MgCO_3$) , calcium carbonate ($CaCO_3$) , strontiumcarbonate ($SrCO_3$) , bariumcarbonate ($BaCO_3$) , lithium carbonate ($LiCO_3$) , sodium carbonate ($Na_2CO_3$) , potassium carbonate ($K_2CO_3$) , magnesium sulfate ($MgSO_4$) , calcium sulfate ($CaSO_4$) , strontium sulfate ($SrSO_4$), barium sulfate ($BaSO_4$) , iron sulfate ($FeSO_4$) , cobalt sulfate ($CoSO_4$) , nickel sulfate ($NiSO_4$) , zinc sulfate ($ZnSO_4$) , lead sulfate ($PbSO_4$), bismuth sulfate ($Bi (SO_4)3$) , strontium nitrate ($Sr(NO_3)_2$) and cesium nitrate ($CsNO_3$).

**23.** A method of manufacturing a functional film according to claim 18, wherein said separation layer (102) contains an inorganic material which reacts with one of a component in an atmosphere and a component contained in an adjacent layer to generate a gas by being heated.

**24.** A method of manufacturing a functional film according to claim 18, wherein said separation layer (202) contains an inorganic material which reacts with one of a component in an atmosphere and a component contained in an adjacent layer to generate a gas by being applied with an electromagnetic wave.

**25.** A method of manufacturing a functional film according to claim 23 or 24, wherein said separation layer (102, 202) contains at least one of metal nitride, metal carbide and metal sulfide.

**26.** A method of manufacturing a functional film according to any one of claims 19 to 25, further comprising, prior to step (b), the step of:

forming an electromagnetic wave absorbing layer (210) on said substrate (101, 201) by using a material which absorbs an electromagnetic wave to generate heat.

**27.** A method of manufacturing a functional film according to claim 26, wherein said electromagnetic wave absorbing layer (210) contains one of carbon, ceramics and glass.

**28.** A method of manufacturing a functional film according to claim 20 or 24, wherein step (d) includes applying an ultraviolet ray toward said separation layer (202).

**29.** A method of manufacturing a functional film according to any one of claims 20, 24, 26 and 27, wherein step (d) includes applying an infrared ray toward one of said separation layer (202) and said electromagnetic wave absorbing layer (210) .

**30.** A method of manufacturing a functional film according to any one of claims 20, 24, 26 and 27, wherein step (d) includes applying a microwave toward one of said separation layer (202) and said electromagnetic wave absorbing layer (210).

**31.** A method of manufacturing a functional film according to any one of claims 18 to 30, wherein said substrate (101, 201) contains one of a single crystal material, which, includes one of an oxide single crystal material and a semiconductor single crystal material, a ceramics material and a glass material.

**32.** A method of manufacturing a functional film according to any one of claims 19 and 23, wherein said substrate (101, 201) contains a metal material.

**33.** A method of manufacturing a functional film according to any one of claims 18 to 32, wherein said functional film (103, 105b, 106a, 203) contains at least one of a piezoelectric material, a pyroelectric material and a ferroelectric material.

**34.** A method of manufacturing a functional film according to any one of claims 18 to 32, wherein said functional film (103, 105b, 106a, 203) contains a superconducting material.

**35.** A method of manufacturing a functional film according to any one of claims 18 to 32, wherein said functional film (103, 105b, 106a, 203) contains a magnetic material.

**36.** A method of manufacturing a functional film according to any one of claims 18 to 32, wherein said functional film (103, 105b, 106a, 203) contains a semiconductor material.

**37.** A method of manufacturing a functional film according to any one of claims 18 to 36, wherein step (c) includes forming an electrode layer (105a) on said separation layer (102, 202), and forming the functional film (105b) on said electrode layer (105a).

**38.** A method of manufacturing a functional film according to any one of claims 18 to 37, wherein step (c) includes forming an electrode layer (106b) on the functional film (106a) formed directly or indirectly on said separation layer (102, -202).

**39.** A method of manufacturing a functional film according to any one of claims 18 to 38, further comprising, prior to step (d), the step of:

(c') providing a second substrate (104, 204) on said layer to be peeled (103, 105, 106, 203);
wherein step (d) includes peeling said layer to be peeled (103, 105, 106, 203) from said substrate (101, 201) and-transferring said layer to said second substrate (104, 204).

**40.** A method of manufacturing a functional film according to claim 39, wherein step (c') includes fixing said second substrate (104, 204) to said layer to be peeled (103, 105, 106, 203) by using an adhesive agent.

**Patentansprüche**

**1.** Struktur zur Funktionsfilm-Mustererzeugung, umfassend:

ein Substrat (101, 201), in dem ein vorbestimmtes Muster gebildet ist;
eine Trennschicht (102, 202), die direkt oder indirekt auf dem Substrat (101, 201) vorgesehen ist; und
eine abzuschälende Schicht (103, 105, 106, 203), die auf der Trennschicht (102, 202) vorgesehen ist und einen durch Verwendung eines Funktionswerkstoffs gebildeten Funktionsfilm (103, 105b, 106a, 203) enthält;
**dadurch gekennzeichnet, dass**
die abzuschälende Schicht (103, 105, 106, 203) von dem Substrat (101, 201) abgeschält wird oder die Bindungskraft zwischen der abzuschälenden Schicht (103, 105, 106, 203) und dem Substrat (101, 201) geringer wird als Ergebnis der Erzeugung eines Gases aus der Trennschicht (102, 202) durch entweder Erhitzen der Trennschicht (102) oder Aufbringen einer elektromagnetischen Welle in Richtung der Trennschicht (202).

**2.** Struktur nach Anspruch 1, bei der die Trennschicht (102) einen anorganischen Werkstoff enthält, der durch Erhitzung unter Erzeugung eines Gases zersetzt wird.

3. Struktur nach Anspruch 1, bei der die Trennschicht (202) einen anorganischen Werkstoff enthält, der durch Aufbringen einer elektromagnetischen Welle unter Erzeugung eines Gases zersetzt wird.

4. Struktur nach Anspruch 2 oder 3, bei der die Trennschicht (102, 202) Carbonat, Sulfat und/oder Nitrat enthält.

5. Struktur nach Anspruch 4, bei der die Trennschicht (102, 202) mindestens einen der folgenden Stoffe enthält: Magnesiumcarbonat ($MgCO_3$), Calciumcarbonat ($CaCO_3$), Strontiumcarbonat ($SrCO_3$), Bariumcarbonat ($BaCO_3$), Lithiumcarbonat ($LiCO_3$), Natriumcarbonat ($Na_2CO_3$), Kaliumcarbonat ($K_2CO_3$), Magnesiumsulfat ($MgSO_4$), Calciumsulfat ($CaSO_4$), Strontiumsulfat ($SrSO_4$), Bariumsulfat ($Ba-SO_4$), Eisensulfat ($FeSO_4$), Cobaltsulfat ($CoSO_4$), Nickelsulfat ($NiSO_4$), Zinksulfat ($ZnSO_4$), Bleisulfat ($PbSO_4$), Bismuthsulfat ($Bi(SO_4)_3$), Strontiumnitrat ($Sr(NO_3)_2$) und Caesiumnitrat ($CsNO_3$).

6. Struktur nach Anspruch 1, bei der die Trennschicht (102) einen anorganischen Werkstoff enthält, der mit einer von einer Komponente in einer Atmosphäre und einer in einer Nachbarschicht bei Erhitzung unter Erzeugung eines Gases reagiert.

7. Struktur nach Anspruch 1, bei der die Trennschicht (202) einen anorganischen Werkstoff enthält, der mit einer von einer Komponente in einer Atmosphäre oder einer in einer Nachbarschicht enthaltenen Komponente bei Aufbringen einer elektromagnetischen Welle unter Erzeugung eines Gases reagiert.

8. Struktur nach Anspruch 6 oder 7, bei der die Trennschicht (102, 202) Metallnitrid, Metallcarbid und/oder Metallsulfid enthält.

9. Struktur nach einem der Ansprüche 2 bis 8, weiterhin umfassend:

   eine elektromagnetische-Wellen-Absorptionsschicht (210), die zwischen dem Substrat (101, 201) und der Trennschicht (102, 202) vorgesehen ist und unter Verwendung eines Werkstoffs gebildet ist, die unter Erzeugung von Wärme eine elektromagnetische Welle absorbiert.

10. Struktur nach Anspruch 9, bei der die elektromagnetische-Wellen-Absorptionsschicht (201) Kohlenstoff, Keramik oder Glas enthält.

11. Struktur nach einem der Ansprüche 1 bis 10, bei der das Substrat (101, 201) einen Einkristallwerkstoff, der einen Oxid-Einkristallwerkstoff oder einen Halbleiter-Einkristallwerkstoff enthält, einen Keramikwerkstoff oder einen Glaswerkstoff enthält.

12. Struktur nach einem der Ansprüche 2, 6 und 11, bei der das Substrat (101, 201) einen Metall-Werkstoff enthält.

13. Struktur nach einem der Ansprüche 1 bis 12, bei der der Funktionsfilm (103, 105b, 106a, 203) mindestens einen der Stoffe piezoelektrischer Werkstoff, pyroelektrischer Werkstoff und ferroelektrischer Werkstoff enthält.

14. Struktur nach einem der Ansprüche 1 bis 12, bei der der Funktionsfilm (103, 105b, 106a, 203) einen supraleitenden Werkstoff enthält.

15. Struktur nach einem der Ansprüche 1 bis 12, bei der der Funktionsfilm (103, 105b, 106a, 203) einen magnetischen Werkstoff enthält.

16. Struktur nach einem der Ansprüche 1 bis 12, bei der der Funktionsfilm (103, 105b, 106a, 203) einen Halbleiterwerkstoff enthält.

17. Struktur nach einem der Ansprüche 1 bis 16, bei der die abzuschälende Schicht (105, 106) einen Funktionsfilm (105b, 106a) und mindestens eine auf mindestens einer von der Oberseite und der Unterseite des Funktionsfilms (105b, 106a) gebildete Elektrodenschicht (105a, 106b) aufweist.

18. Verfahren zum Herstellen eines Funktionsfilms, umfassend folgende Schritte:

(a) Vorbereiten eines Substrats (101, 201), in welchem ein vorbestimmtes Muster ausgebildet ist;

(b) Bilden einer Trennschicht (102, 202) direkt oder indirekt auf dem Substrat (101, 201); und

(c) Bilden einer abzuschälenden Schicht (103, 105, 106, 203), die einen unter Verwendung eines Funktionswerkstoffs gebildeten Funktionsfilm (103, 105b, 106a, 203) enthält, auf der Trennschicht (102, 202), **gekennzeichnet durch**

(d) Abschälen der abzuschälenden Schicht (103, 105, 106, 203) von dem Substrat (101, 201) oder Verringern der Bindungskraft zwischen der abzuschälenden Schicht (103, 105, 106, 203) und dem Substrat (101, 201) als Ergebnis der Erzeugung eines Gases aus der Trennschicht (102, 202) **durch** entweder Erwärmen der Trennschicht (102) oder Aufbringen einer elektromagnetischen Welle in Richtung der Trennschicht (202).

19. Verfahren nach Anspruch 18, bei dem die Trennschicht (102) einen anorganischen Werkstoff enthält, der sich bei Erhitzung unter Erzeugung eines Gases zersetzt.

20. Verfahren nach Anspruch 18, bei dem die Trennschicht (202) einen anorganischen Werkstoff enthält, der sich bei Aufbringen einer elektromagnetischen Welle unter Erzeugung eines Gases zersetzt.

21. Verfahren nach Anspruch 19 oder 20, bei dem die Trennschicht (102, 202) mindestens einen der Stoffe Carbonat, Sulfat und Nitrat enthält.

22. Verfahren nach Anspruch 21, bei dem die Trennschicht (102, 202) mindestens einen folgender Stoffe enthält: Magnesiumcarbonat ($MgCO_3$), Calciumcarbonat ($CaCO_3$), Strontiumcarbonat ($SrCO_3$), Bariumcarbonat ($BaCO_3$), Lithiumcarbonat ($LiCO_3$), Natriumcarbonat ($Na_2CO_3$), Kaliumcarbonat ($K_2CO_3$), Magnesiumsulfat ($MgSO_4$), Calciumsulfat ($CaSO_4$), Strontiumsulfat ($SrSO_4$), Bariumsulfat (Ba-$SO_4$), Eisensulfat ($FeSO_4$), Cobaltsulfat ($CoSO_4$), Nickelsulfat ($NiSO_4$), Zinksulfat ($ZnSO_4$), Bleisulfat ($PbSO_4$), Bismuthsulfat ($Bi(SO_4)_3$), Strontiumnitrat ($Sr(NO_3)_2$) und Caesiumnitrat ($CsNO_3$).

23. Verfahren nach Anspruch 18, bei dem die Trennschicht (101) einen anorganischen Werkstoff enthält, der bei Erhitzung mit einer von einer Komponente in einer Atmosphäre und einer in einer Nachbarschicht enthaltenen Komponente unter Erzeugung eines Gases reagiert.

24. Verfahren nach Anspruch 18, bei dem die Trennschicht (202) einen anorganischen Werkstoff enthält, der bei Aufbringen einer elektrischen Welle mit einer von einer Komponente in einer Atmosphäre und einer in einer Nachbarschicht enthaltenen Komponente unter Erzeugung eines Gases reagiert.

25. Verfahren nach Anspruch 23 oder 24, bei dem die Trennschicht (102, 202) mindestens einen der Stoffe Metallnitrid, Metallcarbid und Metallsulfid enthält.

26. Verfahren nach einem der Ansprüche 19 bis 25, weiterhin vor dem Schritt (b) folgenden Schritt enthaltend:

Bilden einer elektromagnetische-Wellen-Absorptionsschicht (210) auf dem Substrat (101, 201) unter Verwendung eines Werkstoffs, der unter Erzeugung von Wärme eine elektromagnetische Welle absorbiert.

27. Verfahren nach Anspruch 26, bei dem die elektromagnetische-Wellen-Absorptionsschicht (201) einen der Stoffe Kohlenstoff, Keramik und Glas enthält.

28. Verfahren nach Anspruch 20 oder 24, bei dem der Schritt (d) das Aufbringen von Ultraviolettstrahlen in Richtung auf die Trennschicht (202) enthält.

29. Verfahren nach einem der Ansprüche 20, 24, 26 und 27, bei dem der Schritt (d) das Aufbringen von Infrarotstrahlen in Richtung auf eine von der Trennschicht (202) und der elektromagnetische-Wellen-Absorptionsschicht (210) enthält.

30. Verfahren nach einem der Ansprüche 20, 24, 26 und 27, bei dem der Schritt (d) das Aufbringen einer Mikrowelle in Richtung auf eine von der Trennschicht (202) und der elektromagnetische-Wellen-Absorptionsschicht (210) enthält.

31. Verfahren nach einem der Ansprüche 18 bis 30, bei dem das Substrat (101, 201) einen Einkristallwerkstoff, der einen Oxid-Einkristallwerkstoff oder einen Halbleiter-Einkristallwerkstoff enthält, einen Keramikwerkstoff oder einen Glaswerkstoff enthält.

32. Verfahren nach einem der Ansprüche 19 und 23, bei dem das Substrat (101, 201) einen Metall-Werkstoff enthält.

33. Verfahren nach einem der Ansprüche 18 bis 32, bei dem der Funktionsfilm (103, 105b, 106a, 203) mindestens einen der Stoffe piezoelektrischer Werkstoff, pyroelektrischer Werkstoff und ferroelektrischer Werkstoff enthält.

34. Verfahren nach einem der Ansprüche 18 bis 32, bei dem der Funktionsfilm (103, 105b, 106a, 203) einen supraleitenden Werkstoff enthält.

35. Verfahren nach einem der Ansprüche 18 bis 32, bei der der Funktionsfilm (103, 105b, 106a, 203) einen magnetischen Werkstoff enthält.

36. Verfahren nach einem der Ansprüche 18 bis 32, bei der der Funktionsfilm (103, 105b, 106a, 203) einen Halbleiterwerkstoff enthält.

37. Verfahren nach einem der Ansprüche 18 bis 36, bei dem der Schritt (c) das Ausbilden einer Elektrodenschicht (105a) auf der Trennschicht (102, 202) und das Ausbilden des Funktionsfilms (105b) auf der Elektrodenschicht (105a) enthält.

38. Verfahren nach einem der Ansprüche 18 bis 37, bei dem der Schritt (c) das Ausbilden einer Elektrodenschicht (106b) auf dem Funktionsfilm (106a) enthält, welcher direkt oder indirekt auf der Trennschicht (102, 202) gebildet ist.

39. Verfahren nach einem der Ansprüche 18 bis 38, weiterhin umfassend, vor dem Schritt (d) den Schritt:

   (c') Bereitstellen eines zweiten Substrats (104, 204) auf der abzuschälenden Schicht (103, 105, 106, 203);
   wobei der Schritt (d) das Abschälen der abzuschälenden Schicht (103, 105, 106, 203) von dem Substrat (101, 201) und das Transferieren der Schicht auf das zweite Substrat (104, 204) enthält.

40. Verfahren nach Anspruch 39, bei dem der Schritt (c') das Fixieren des zweiten Substrats (104, 204) an der abzuschälenden Schicht (103, 105, 106, 203) mit Hilfe eines Klebstoffs enthält.


**Revendications**

1. Structure pour la formation d'un motif de film fonctionnel comprenant :

   un substrat (101, 201) dans lequel un motif prédéterminé est formé ;
   une couche de séparation (102, 202) disposée directement ou indirectement sur ledit substrat (101, 201) ; et
   une couche destinée à être séparée (103, 105, 106, 203) disposée sur ladite couche de séparation (102, 202) et contenant un film fonctionnel (103, 105b, 106a, 203) formé au moyen d'un matériau fonctionnel ; **caractérisée en ce que** :

   ladite couche destinée à être séparée (103, 105, 106, 203) est séparée dudit substrat (101, 201) ou la force de liaison entre ladite couche destinée à être séparée (103, 105, 106, 203) et ledit substrat (101, 201) devient plus basse par suite de la formation d'un gaz depuis ladite couche de séparation (102, 202) par l'un d'un chauffage de ladite couche de séparation (102) et de l'application d'une onde électromagnétique en direction de ladite couche de séparation (202).

2. Structure pour la formation d'un motif de film fonctionnel selon la revendication 1, où ladite couche de séparation (102) contient un matériau inorganique qui est décomposé pour former un gaz en étant chauffé.

3. Structure pour la formation d'un motif de film fonctionnel selon la revendication 1, où ladite couche de séparation (202) contient un matériau inorganique qui est décomposé pour former un gaz par application d'une onde électromagnétique.

4. Structure pour la formation d'un motif de film fonctionnel selon la revendication 2 ou 3, où ladite couche de séparation (102, 202) contient au moins l'un d'un carbonate, sulfate et nitrate.

**5.** Structure pour la formation d'un motif de film fonctionnel selon la revendication 4, où ladite couche de séparation (102, 202) contient au moins l'un de carbonate de magnésium ($MgCO_3$), carbonate de calcium ($CaCO_3$), carbonate de strontium ($SrCO_3$), carbonate de baryum ($BaCO_3$), carbonate de lithium ($LiCO_3$), carbonate de sodium ($Na_2CO_3$), carbonate de potassium ($K_2CO_3$), sulfate de magnésium ($MgSO_4$), sulfate de calcium ($CaSO_4$), sulfate de strontium ($SrSO_4$), sulfate de baryum ($BaSO_4$), sulfate de fer ($FeSO_4$), sulfate de cobalt ($CoSO_4$), sulfate de nickel ($NiSO_4$), sulfate de zinc ($ZnSO_4$), sulfate de plomb ($PbSO_4$), sulfate de bismuth ($Bi(SO_4)_3$), nitrate de strontium ($Sr(NO_3)_2$) et nitrate de césium ($CsNO_3$).

**6.** Structure pour la formation d'un motif de film fonctionnel selon la revendication 1, où ladite couche de séparation (102) contient un matériau inorganique qui réagit avec l'un d'un composant dans une atmosphère et d'un composant contenu dans une couche adjacente pour former un gaz par chauffage.

**7.** Structure pour la formation d'un motif de film fonctionnel selon la revendication 1, où ladite couche de séparation (202) contient un matériau inorganique qui réagit avec l'un d'un composant dans une atmosphère et d'un composant contenu dans une couche adjacente pour former un gaz par application d'une onde électromagnétique.

**8.** Structure pour la formation d'un motif de film fonctionnel selon la revendication 6 ou 7, où ladite couche de séparation (102, 202) contient au moins l'un d'un nitrure métallique, d'un carbure métallique et d'un sulfure métallique.

**9.** Structure pour la formation d'un motif de film fonctionnel selon l'une quelconque des revendications 2 à 8, comprenant en outre :

une couche absorbant les ondes électromagnétiques (210) disposée entre ledit substrat (101, 201) et ladite couche de séparation (102, 202) et formée au moyen d'un matériau qui absorbe une onde électromagnétique pour produire de la chaleur.

**10.** Structure pour la formation d'un motif de film fonctionnel selon la revendication 9, où ladite couche absorbant les ondes électromagnétiques (210) contient l'un de carbone, d'une céramique et d'un verre.

**11.** Structure pour la formation d'un motif de film fonctionnel selon l'une quelconque des revendications 1 à 10, où ledit substrat (101, 201) contient l'un d'un matériau monocristallin, qui inclut l'un d'un matériau monocristallin de type oxyde et d'un matériau monocristallin de type semi-conducteur, d'un matériau de type céramique et d'un matériau de type verre.

**12.** Structure pour la formation d'un motif de film fonctionnel selon l'une quelconque des revendications 2, 6 et 11, où ledit substrat (101, 201) contient un matériau métallique.

**13.** Structure pour la formation d'un motif de film fonctionnel selon l'une quelconque des revendications 1 à 12, où ledit film fonctionnel (103, 105b, 106a, 203) contient au moins l'un d'un matériau piézoélectrique, d'un matériau pyroélectrique et d'un matériau ferroélectrique.

**14.** Structure pour la formation d'un motif de film fonctionnel selon l'une quelconque des revendications 1 à 12, où ledit film fonctionnel (103, 105b, 106a, 203) contient un matériau supraconducteur.

**15.** Structure pour la formation d'un motif de film fonctionnel selon l'une quelconque des revendications 1 à 12, où ledit film fonctionnel (103, 105b, 106a, 203) contient un matériau magnétique.

**16.** Structure pour la formation d'un motif de film fonctionnel selon l'une quelconque des revendications 1 à 12, où ledit film fonctionnel (103, 105b, 106a, 203) contient un matériau semi-conducteur.

**17.** Structure pour la formation d'un motif de film fonctionnel selon l'une quelconque des revendications 1 à 16, où ladite couche destinée à être séparée (105, 106) a un film fonctionnel (105b, 106a) et au moins une couche d'électrode (105a, 106b) formée sur au moins l'une d'une surface supérieure et d'une surface inférieure du film fonctionnel (105b, 106a).

**18.** Procédé de fabrication d'un film fonctionnel comprenant les étapes de :

(a) préparation d'un substrat (101, 201) dans lequel un motif prédéterminé est formé ;

(b) formation d'une couche de séparation (102, 202) directement ou indirectement sur ledit substrat (101, 201) ; et
(c) formation d'une couche destinée à être séparée (103, 105, 106, 203) contenant un film fonctionnel (103, 105b, 106a, 203), qui est formé au moyen d'un matériau fonctionnel, sur ladite couche de séparation (102, 202) ; **caractérisé par** :
(d) la séparation de ladite couche destinée à être séparée (103, 105, 106, 203) d'avec ledit substrat (101, 201) ou la réduction de la force de liaison entre ladite couche destinée à être séparée (103, 105, 106, 203) et ledit substrat (101, 201) par suite de la formation d'un gaz depuis ladite couche de séparation (102, 202) par l'un d'un chauffage de ladite couche de séparation (102) et de l'application d'une onde électromagnétique en direction de ladite couche de séparation (202).

19. Procédé de fabrication d'un film fonctionnel selon la revendication 18, où ladite couche de séparation (102) contient un matériau inorganique qui est décomposé pour former un gaz en étant chauffé.

20. Procédé de fabrication d'un film fonctionnel selon la revendication 18, où ladite couche de séparation (202) contient un matériau inorganique qui est décomposé pour former un gaz par application d'une onde électromagnétique.

21. Procédé de fabrication d'un film fonctionnel selon la revendication 19 ou 20, où ladite couche de séparation (102, 202) contient au moins l'un d'un carbonate, sulfate et nitrate.

22. Procédé de fabrication d'un film fonctionnel selon la revendication 21, où ladite couche de séparation (102, 202) contient au moins l'un de carbonate de magnésium ($MgCO_3$), carbonate de calcium ($CaCO_3$), carbonate de strontium ($SrCO_3$), carbonate de baryum ($BaCO_3$), carbonate de lithium ($LiCO_3$), carbonate de sodium ($Na_2CO_3$), carbonate de potassium ($K_2CO_3$), sulfate de magnésium ($MgSO_4$), sulfate de calcium ($CaSO_4$), sulfate de strontium ($SrSO_4$), sulfate de baryum ($BaSO_4$), sulfate de fer ($FeSO_4$), sulfate de cobalt ($CoSO_4$), sulfate de nickel ($NiSO_4$), sulfate de zinc ($ZnSO_4$), sulfate de plomb ($PbSO_4$), sulfate de bismuth ($Bi(SO_4)_3$), nitrate de strontium ($Sr(NO_3)_2$) et nitrate de césium ($CsNO_3$).

23. Procédé de fabrication d'un film fonctionnel selon la revendication 18, où ladite couche de séparation (102) contient un matériau inorganique qui réagit avec l'un d'un composant dans une atmosphère et d'un composant contenu dans une couche adjacente pour former un gaz par chauffage.

24. Procédé de fabrication d'un film fonctionnel selon la revendication 18, où ladite couche de séparation (202) contient un matériau inorganique qui réagit avec l'un d'un composant dans une atmosphère et d'un composant contenu dans une couche adjacente pour former un gaz par application d'une onde électromagnétique.

25. Procédé de fabrication d'un film fonctionnel selon la revendication 23 ou 24, où ladite couche de séparation (102, 202) contient au moins l'un d'un nitrure métallique, d'un carbure métallique et d'un sulfure métallique.

26. Procédé de fabrication d'un film fonctionnel selon l'une quelconque des revendications 19 à 25, comprenant en outre, avant l'étape (b), l'étape de :

  formation d'une couche absorbant les ondes électromagnétiques (210) sur ledit substrat (101, 201) au moyen d'un matériau qui absorbe une onde électromagnétique pour produire de la chaleur.

27. Procédé de fabrication d'un film fonctionnel selon la revendication 26, où ladite couche absorbant les ondes électromagnétiques (210) contient l'un de carbone, d'une céramique et d'un verre.

28. Procédé de fabrication d'un film fonctionnel selon la revendication 20 ou 24, où l'étape (d) inclut l'application d'un rayonnement ultraviolet en direction de ladite couche de séparation (202).

29. Procédé de fabrication d'un film fonctionnel selon l'une quelconque des revendications 20, 24, 26 et 27, où l'étape (d) inclut l'application d'un rayonnement infrarouge en direction de l'une de ladite couche de séparation (202) et de ladite couche absorbant les ondes électromagnétiques (210).

30. Procédé de fabrication d'un film fonctionnel selon l'une quelconque des revendications 20, 24, 26 et 27, où l'étape (d) inclut l'application d'une micro-onde en direction de l'une de ladite couche de séparation (202) et de ladite couche absorbant les ondes électromagnétiques (210).

**31.** Procédé de fabrication d'un film fonctionnel selon l'une quelconque des revendications 18 à 30, où ledit substrat (101, 201) contient l'un d'un matériau monocristallin, qui inclut l'un d'un matériau monocristallin de type oxyde et d'un matériau monocristallin de type semi-conducteur, d'un matériau de type céramique et d'un matériau de type verre.

**32.** Procédé de fabrication d'un film fonctionnel selon l'une quelconque des revendications 19 et 23, où ledit substrat (101, 201) contient un matériau métallique.

**33.** Procédé de fabrication d'un film fonctionnel selon l'une quelconque des revendications 18 à 32, où ledit film fonctionnel (103, 105b, 106a, 203) contient au moins l'un d'un matériau piézoélectrique, d'un matériau pyroélectrique et d'un matériau ferroélectrique.

**34.** Procédé de fabrication d'un film fonctionnel selon l'une quelconque des revendications 18 à 32, où ledit film fonctionnel (103, 105b, 106a, 203) contient un matériau supraconducteur.

**35.** Procédé de fabrication d'un film fonctionnel selon l'une quelconque des revendications 18 à 32, où ledit film fonctionnel (103, 105b, 106a, 203) contient un matériau magnétique.

**36.** Procédé de fabrication d'un film fonctionnel selon l'une quelconque des revendications 18 à 32, où ledit film fonctionnel (103, 105b, 106a, 203) contient un matériau semi-conducteur.

**37.** Procédé de fabrication d'un film fonctionnel selon l'une quelconque des revendications 18 à 36, où l'étape (c) inclut la formation d'une couche d'électrode (105a) sur ladite couche de séparation (102, 202) et la formation du film fonctionnel (105b) sur ladite couche d'électrode (105a).

**38.** Procédé de fabrication d'un film fonctionnel selon l'une quelconque des revendications 18 à 37, où l'étape (c) inclut la formation d'une couche d'électrode (106b) sur le film fonctionnel (106a) formé directement ou indirectement sur ladite couche de séparation (102, 202).

**39.** Procédé de fabrication d'un film fonctionnel selon l'une quelconque des revendications 18 à 38, comprenant en outre, avant l'étape (d), l'étape de :

(c') disposition d'un second substrat (104, 204) sur ladite couche destinée à être séparée (103, 105, 106, 203) ; où l'étape (d) inclut la séparation de ladite couche destinée à être séparée (103, 105, 106, 203) dudit substrat (101, 201) et le transfert de ladite couche audit second substrat (104, 204).

**40.** Procédé de fabrication d'un film fonctionnel selon la revendication 39, où l'étape (c') inclut la fixation dudit second substrat (104, 204) à ladite couche destinée à être séparée (103, 105, 106, 203) au moyen d'un agent adhésif.

# FIG.1

```
                              ┌─────────────┐
                              │    START    │
                              └──────┬──────┘
                                     ↓
                    ┌────────────────────────────────┐
                    │       PREPARE SUBSTRATE         │─ S1
                    └────────────────┬───────────────┘
                                     ↓
FABRICATION OF      ┌────────────────────────────────┐
STRUCTURE FOR       │     FORM SEPARATION LAYER       │─ S2
FUNCTIONAL FILM     └────────────────┬───────────────┘
PATTERN FORMATION                    ↓
                    ┌────────────────────────────────┐
                    │     FORM LAYER TO BE PEELED     │─ S3
                    └────────────────┬───────────────┘
                                     ↓
                    ┌────────────────────────────────┐
                    │ PROVIDE STRUCTURE FOR FUNCTIONAL│
                    │   FILM PATTERN FORMATION ON     │─ S4
                    │    SUBSTRATE FOR TRANSFER       │
                    └────────────────┬───────────────┘
                                     ↓
                    ┌────────────────────────────────┐
                    │ PERFORM HEAT TREATMENT AND SO ON│─ S5
                    └────────────────┬───────────────┘
                                     ↓
                              ┌─────────────┐
                              │     END     │
                              └─────────────┘
```

*FIG.2A*

101

*FIG.2B*

102

102

101

*FIG.2C*

103
102

103
102

101

*FIG.2D*

101

102
103

102
103

104

*FIG.2E*

101

GAS

103
GAS

103

104

*FIG.2F*

103

104

FIG.3A

203
202

203
202
201

ELECTROMAGNETIC WAVE

FIG.3B

201
GAS
203
GAS
203
204

FIG.3C

203
204

*FIG.4A*

~203
~202
~210

~203
~202
~210

~201

ELECTROMAGNETIC WAVE
⇩

*FIG.4B*

~201
GAS
~210
~203
GAS
~210
~203
~204

*FIG.5A*

304
303
302
303
302
301

*FIG.5B*

304
303
302
303
302
301

*FIG.5C*

303
304

FIG.6

FIG.7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP P200564289 A

- WO 03032384 A1